# EUROPEAN PATENT APPLICATION

(11) **EP 4 783 437 A1**
(43) Date of publication of application: **29.07.2026**
(21) Application number: 25796635.8
(22) Date of filing: 22.09.2025
(51) Int. Cl.: H02M 1/00, G01R 31/327, H02M 1/36

(54) **POWER CONVERTER AND CONTROL METHOD THEREFOR**

(30) Priority: 09.10.2024 CN 202411406248
(71) Applicant: Huawei Digital Power Technologies Co., Ltd., Shenzhen, Guangdong 518043 (CN)
(72) Inventor: YE, Yong, Shenzhen, Guangdong 518043 (CN); SHI, Hui, Shenzhen, Guangdong 518043 (CN); HU, Tianqi, Shenzhen, Guangdong 518043 (CN); HUI, Libin, Shenzhen, Guangdong 518043 (CN); HAN, Lang, Shenzhen, Guangdong 518043 (CN)
(74) Representative: Gill Jennings & Every LLP
(86) International application number: PCT/CN2025/122828
(87) International publication number: WO 2026/077214

(57) **Abstract**

Embodiments of this application disclose a power converter and a control method thereof, and relate to the field of energy technologies, to resolve a problem of how to accurately determine whether an arc-fault circuit interrupter is functioning properly. Specifically, in the power converter, a controller is configured to output a pulse signal. A noise signal conditioning circuit is configured to receive the pulse signal, and output a noise signal based on the pulse signal. A current transformer is configured to receive the noise signal and perform sampling, to output a sampled signal. A sampling signal conditioning circuit is configured to receive the sampled signal, and output a conditioned signal based on the sampled signal. The controller is further configured to: when an absolute value of a difference between a frequency of the conditioned signal and a frequency of the pulse signal is less than or equal to a frequency threshold, and a gain of the conditioned signal is greater than or equal to a gain threshold corresponding to the frequency of the pulse signal, control a power conversion circuit to start operating.

## Description

### CROSS-REFERENCE TO RELATED APPLICATIONS

This application claims priority to Chinese Patent Application No. 202411406248.8, filed with the China National Intellectual Property Administration on October 9, 2024 and entitled " POWER CONVERTER AND CONTROL METHOD THEREOF ", which is incorporated herein by reference in its entirety.

### TECHNICAL FIELD

This application relates to the field of energy technologies, and in particular, to a power converter and a control method thereof.

### BACKGROUND

A photovoltaic power generation system may include a photovoltaic inverter. A micro string inverter is a photovoltaic inverter. An input of the micro string inverter is used to connect to a photovoltaic array, and an output of the micro string inverter is used to connect to a load or a power grid. Alternatively, the photovoltaic power generation system may further include an optimizer, where an input of the optimizer is used to connect to a photovoltaic array, and an output of the optimizer is used to connect to an input of the photovoltaic inverter.

The photovoltaic power generation system has a long service life. Faults such as cable aging or unreliable wire terminal connections are likely to cause direct current arc faults, resulting in electrical fires. To avoid the foregoing problem, an arc-fault circuit interrupter (arc-fault circuit interrupter, AFCI) may be disposed in the photovoltaic inverter or the optimizer. The arc-fault circuit interrupter may also be referred to as an arc-fault circuit breaker.

However, how to determine whether the arc-fault circuit interrupter is functioning properly and when the arc-fault circuit interrupter is functioning properly, control a power conversion circuit in the photovoltaic inverter or the optimizer to start operating, thereby improving reliability and security of the photovoltaic inverter or the optimizer, becomes an urgent problem that needs to be resolved.

### SUMMARY

Embodiments of this application provide a power converter and a control method thereof, to resolve a problem of how to accurately determine whether an arc-fault circuit interrupter is functioning properly.

To achieve the foregoing objectives, the following technical solutions are used in embodiments of this application.

According to a first aspect, an embodiment of this application provides a power converter. The power converter includes a current transformer, a power conversion circuit, a noise signal conditioning circuit, a sampling signal conditioning circuit, and a controller. The noise signal conditioning circuit includes a first resistor and a capacitor that are connected in series. The current transformer is configured to be connected between a photovoltaic array and the power conversion circuit. The current transformer is configured to detect a current output by the photovoltaic array, and the power conversion circuit is configured to perform power conversion on a direct current output by the photovoltaic array. The current transformer and the sampling signal conditioning circuit are configured to perform direct current arc detection. The controller is configured to output a pulse signal. The noise signal conditioning circuit is configured to receive the pulse signal, and output a noise signal based on the pulse signal. The current transformer is configured to receive the noise signal and perform sampling, to output a sampled signal. The sampling signal conditioning circuit is configured to receive the sampled signal, and output a conditioned signal based on the sampled signal. The controller is further configured to: when an absolute value of a difference between a frequency of the conditioned signal and a frequency of the pulse signal is less than or equal to a frequency threshold, and a gain of the conditioned signal is greater than or equal to a gain threshold corresponding to the frequency of the pulse signal, control the power conversion circuit to start operating.

Based on this solution, when the absolute value of the difference between the frequency of the conditioned signal and the frequency of the pulse signal is less than or equal to the frequency threshold, and the gain of the conditioned signal is greater than or equal to the gain threshold corresponding to the frequency of the pulse signal, the controller controls the power conversion circuit to start operating. Therefore, the power conversion circuit can be controlled to start operating when it is more accurately determined that an arc-fault circuit interrupter in the power converter is functioning properly, improving reliability and security of the power converter. In addition, the noise signal conditioning circuit includes the first resistor and the capacitor that are connected in series. A circuit topology of the noise signal conditioning circuit is simpler, which can reduce costs of the power converter.

With reference to the first aspect, in a possible implementation, the controller is further configured to: when the absolute value of the difference between the frequency of the conditioned signal and the frequency of the pulse signal is greater than the frequency threshold, or the gain of the conditioned signal is less than the gain threshold corresponding to the frequency of the pulse signal, control the power converter to shut down.

Based on this solution, when the absolute value of the difference between the frequency of the conditioned signal and the frequency of the pulse signal is greater than the frequency threshold, or the gain of the conditioned signal is less than the gain threshold corresponding to the frequency of the pulse signal, the controller determines that the arc-fault circuit interrupter in the power converter does not function properly, generates an alarm to indicate that the arc-fault circuit interrupter does not function properly, and controls the power converter to shut down, thereby improving reliability and security of the power converter.

With reference to the first aspect, in a possible implementation, the controller is specifically configured to: during one direct current arc detection, output the pulse signal whose frequency varies based on a fixed step. The frequency varying based on the fixed step includes that the frequency is adjusted from a first frequency to a second frequency based on the fixed step, and the first frequency is less than the second frequency, or the first frequency is greater than the second frequency.

In comparison with sequentially outputting a pulse signal at each frequency by the controller during one direct current arc detection, based on this solution, during one direct current arc detection, the controller outputs the pulse signal whose frequency varies based on the fixed step/ This solution reduces a quantity of conditioned signals and pulse signals that need to be compared by the controller. Therefore, it can be more quickly determined whether the arc-fault circuit interrupter in the power converter is functioning properly, and startup efficiency of the power converter can be improved.

With reference to the first aspect, in a possible implementation, the fixed step includes 5 kHz, 10 kHz, 15 kHz, or 20 kHz.

With reference to the first aspect, in a possible implementation, a frequency range threshold of the pulse signal is greater than or equal to 20 kHz and less than or equal to 60 kHz.

Based on this solution, the frequency range threshold of the pulse signal is greater than or equal to 20 kHz and less than or equal to 60 kHz. The frequency range threshold of the pulse signal output by the controller is reduced. This solution reduces a quantity of conditioned signals and pulse signals that need to be compared by the controller. Therefore, it can be more quickly determined whether the arc-fault circuit interrupter in the power converter is functioning properly, and startup efficiency of the power converter can be improved.

With reference to the first aspect, in a possible implementation, the power converter further includes a drive circuit. The drive circuit is disposed between the controller and the noise signal conditioning circuit, and the sampling signal conditioning circuit is a second-order band-pass filter.

Based on this solution, the drive circuit is disposed between the controller and the noise signal conditioning circuit, so that an additional drive capability can be provided when a drive capability of the controller is insufficient, thereby avoiding that the controller cannot detect whether the arc-fault circuit interrupter is functioning properly, and improving reliability of the power converter.

With reference to the first aspect, in a possible implementation, the current transformer includes a second resistor, and a first coil, a second coil, a third coil, and a fourth coil that are magnetically coupled to each other. One end of the first coil is configured to connect to a positive electrode of the photovoltaic array, and the other end of the first coil is connected to a positive input end of the power conversion circuit. One end of the second coil is configured to connect to a negative electrode of the photovoltaic array, and the other end of the second coil is connected to a negative input end of the power conversion circuit. One end of the third coil is connected to an output end of the noise signal conditioning circuit, and the other end of the third coil and one end of the fourth coil are connected to a ground terminal. The other end of the fourth coil is connected to an input end of the sampling signal conditioning circuit, and the second resistor is connected to the fourth coil in parallel.

With reference to the first aspect, in a possible implementation, the power conversion circuit is a DCDC power conversion circuit. An output of the power converter is configured to connect to an input of the inverter, or the output of the power converter is configured to connect to an output of at least one power converter in series and then to the input of the inverter, and an output of the inverter is configured to connect to a power grid or a load.

With reference to the first aspect, in a possible implementation, the power conversion circuit is a DCAC power conversion circuit, and an output of the power conversion circuit is configured to connect to a power grid or a load. The controller is specifically configured to: when the absolute value of the difference between the frequency of the conditioned signal and the frequency of the pulse signal is less than or equal to the frequency threshold, and the gain of the conditioned signal is greater than or equal to the gain threshold corresponding to the frequency of the pulse signal, control the power conversion circuit to establish a connection to the power grid or the load; or when the absolute value of the difference between the frequency of the conditioned signal and the frequency of the pulse signal is greater than the frequency threshold, or the gain of the conditioned signal is less than the gain threshold corresponding to the frequency of the pulse signal, control the power conversion circuit to disconnect from the power grid or the load.

According to a second aspect, an embodiment of this application provides a power converter control method, applied to a power converter. The method includes: generating a pulse signal; generating a noise signal based on the pulse signal; generating a sampled signal based on the noise signal; generating a conditioned signal based on the sampled signal; and when an absolute value of a difference between a frequency of the conditioned signal and a frequency of the pulse signal is less than or equal to a frequency threshold, and a gain of the conditioned signal is greater than or equal to a gain threshold corresponding to the frequency of the pulse signal, controlling a power conversion circuit in the power converter to start operating.

With reference to the second aspect, in a possible implementation, the method further includes: when the absolute value of the difference between the frequency of the conditioned signal and the frequency of the pulse signal is greater than the frequency threshold, or the gain of the conditioned signal is less than the gain threshold corresponding to the frequency of the pulse signal, controlling the power converter to shut down.

With reference to the second aspect, in a possible implementation, generating the pulse signal includes: during one direct current arc detection, generating the pulse signal whose frequency varies based on a fixed step. The frequency varying based on the fixed step includes that the frequency is adjusted from a first frequency to a second frequency based on the fixed step, and the first frequency is less than the second frequency, or the first frequency is greater than the second frequency.

With reference to the second aspect, in a possible implementation, the fixed step includes 5 kHz, 10 kHz, 15 kHz, or 20 kHz.

With reference to the second aspect, in a possible implementation, a frequency range threshold of the pulse signal is greater than or equal to 20 kHz and less than or equal to 60 kHz.

According to a third aspect, an embodiment of this application provides a photovoltaic power generation system. The photovoltaic power generation system includes a plurality of optimizers and a photovoltaic inverter. Each optimizer may be configured to connect to one photovoltaic array. Output ends of the plurality of optimizers are connected in series and then connected to an input end of the photovoltaic inverter. An output end of the photovoltaic inverter is configured to connect to a power grid or a load. The optimizer may also be referred to as a power converter. The power converter is the power converter according to any one of the first aspect or the possible implementations of the first aspect.

According to a fourth aspect, an embodiment of this application provides a photovoltaic power generation system. The photovoltaic power generation system includes a plurality of micro string inverters. Each micro string inverter may be configured to connect to one photovoltaic array. Each photovoltaic array includes at least one photovoltaic module. Output ends of the plurality of micro string inverters are connected in parallel by using power lines, and the power lines are connected to a power grid or a load. The micro string inverter may be referred to as a power converter, and the power converter is the power converter according to any one of the first aspect or the possible implementations of the first aspect.

For descriptions of the second aspect to the fourth aspect in this application, refer to the detailed descriptions of the first aspect. In addition, for beneficial effects of the second aspect to the fourth aspect, refer to the beneficial effect analyses of the first aspect. Details are not described herein again.

### BRIEF DESCRIPTION OF DRAWINGS

FIG. 1 is a schematic of a circuit topology of a photovoltaic inverter according to an embodiment of this application;
FIG. 2 is a schematic of a circuit topology of a photovoltaic power generation system according to an embodiment of this application;
FIG. 3 is a schematic of a circuit topology of another photovoltaic power generation system according to an embodiment of this application;
FIG. 4 is a schematic of a circuit topology of a power converter according to an embodiment of this application;
FIG. 5 is a schematic of a circuit topology of another power converter according to an embodiment of this application;
FIG. 6 is a Bode plot according to an embodiment of this application;
FIG. 7 is a diagram of pulse signal frequency adjustment according to an embodiment of this application; and
FIG. 8 is a schematic flowchart of a power converter control method according to an embodiment of this application.

### DESCRIPTION OF EMBODIMENTS

The making and use of embodiments are discussed in detail below. However, it should be appreciated that many applicable inventive concepts provided in this application may be implemented in a plurality of specific environments. The discussed specific embodiments are merely used to describe specific manners to implement and use this specification and this technology, and do not limit the scope of this application.

Unless otherwise defined, all technical terms used herein have same meanings as those commonly known to a person of ordinary skill in the art.

Circuits or other components may be described as or referred to as "configured to" perform one or more tasks. In this case, the term "configured to" is used for implying a structure by indicating that a circuit/component includes a structure (for example, a circuit system) that performs one or more tasks during operation. Therefore, even when a specified circuit/component is currently not operable (for example, not opened), the circuit/component may also be referred to as being configured to perform the task. Circuits/components used in conjunction with the "configured to" phrase include hardware, for example, a circuit for performing an operation.

The following describes the technical solutions in embodiments of this application with reference to the accompanying drawings in embodiments of this application. In this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof indicates any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural. In addition, in embodiments of this application, terms such as "first" and "second" do not limit a quantity or an execution sequence.

In this application, the term "example", "for example", or the like is used to give an example, an illustration, or a description. Any embodiment or design scheme described as an "example" or "for example" in this application should not be explained as being more preferred or having more advantages than another embodiment or design scheme. To be precise, use of the word such as "example" or "for example" is intended to present a relative concept in a specific manner.

Before embodiments of this application are described, technical terms and background technologies in this application are first described.

Current transformer (current transformer, CT): A current transformer is an instrument that converts a primary-side high current into a secondary-side low current for measurement according to an electromagnetic induction principle. The current transformer includes a closed iron core and a winding, and the winding may also be referred to as a coil.

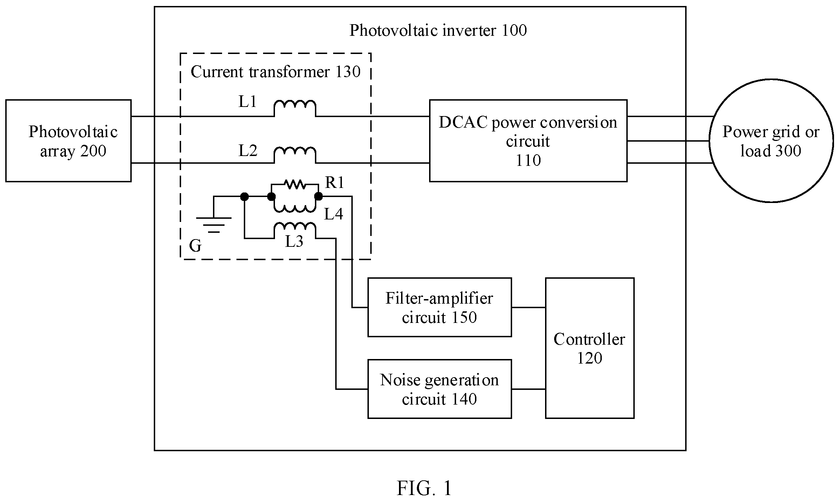

A photovoltaic power generation system has a long service life. Faults such as cable aging or unreliable wire terminal connections are likely to cause direct current arc faults, resulting in electrical fires. To avoid the foregoing problem, an arc-fault circuit interrupter may be disposed in a photovoltaic inverter or an optimizer. For example, the photovoltaic inverter is used as an example. FIG. 1 is a schematic of a circuit topology of a photovoltaic inverter 100 according to an embodiment of this application. The photovoltaic inverter 100 includes a direct current to alternating current (direct current to alternating current, DCAC) power conversion circuit 110, a controller 120, a current transformer 130, a noise generation circuit 140, and a filter-amplifier circuit 150. A circuit including the current transformer 130, the noise generation circuit 140, and the filter-amplifier circuit 150 may be referred to as the arc-fault circuit interrupter.

The current transformer 130 is configured to be connected between a photovoltaic array 200 and the DCAC power conversion circuit 110, and an output of the DCAC power conversion circuit 110 is configured to connect to a power grid or a load 300. The current transformer 130 is configured to detect a current output by the photovoltaic array 200. The DCAC power conversion circuit 110 is configured to convert a direct current output by the photovoltaic array 200 into an alternating current and transmit the alternating current to the power grid or the load 300. The current transformer 130 and the filter-amplifier circuit 150 are configured to perform direct current arc detection.

Specifically, refer to FIG. 1. The current transformer 130 includes a first resistor R1, and a first coil L1, a second coil L2, a third coil L3, and a fourth coil L4 that are magnetically coupled to each other. The first coil L1 is connected between a positive electrode of the photovoltaic array 200 and a positive input end of the DCAC power conversion circuit 110. The second coil L2 is connected between a negative electrode of the photovoltaic array 200 and a negative input end of the DCAC power conversion circuit 110. One end of the third coil L3 is connected to an output end of the noise generation circuit 140. An input end of the noise generation circuit 140 is connected to an output end of the controller 120. The other end of the third coil L3 and one end of the fourth coil L4 are connected to a ground terminal (ground, G). The other end of the fourth coil L4 is connected to an input end of the filter-amplifier circuit 150. An output end of the filter-amplifier circuit 150 is connected to an input end of the controller 120. The first resistor R1 is connected to the fourth coil L4 in parallel.

A circuit including the third coil L3 and the noise generation circuit 140 may be referred to as a self-checking circuit. A circuit including the fourth coil L4, the first resistor R1, and the filter-amplifier circuit 150 may be referred to as a detection circuit. The self-checking circuit is configured to check whether a function of the detection circuit is normal, to determine whether the arc-fault circuit interrupter is functioning properly. The detection circuit is configured to detect whether there is a direct current arc in the photovoltaic inverter 100.

When it is determined whether the arc-fault circuit interrupter is functioning properly, the controller 120 sends a control signal to the noise generation circuit 140, so that the noise generation circuit 140 generates a noise signal whose spectral characteristic is the same as that of an arc noise signal, and transmits the noise signal to the third coil L3 in the current transformer 130. The fourth coil L4 in the current transformer 130 samples the noise signal to output a sampled signal. The filter-amplifier circuit 150 filters the sampled signal to output a conditioned signal. The controller 120 may determine, by comparing whether a frequency of the conditioned signal is the same as a frequency of the noise signal, whether the arc-fault circuit interrupter is functioning properly. When the controller 120 controls, based on this, the photovoltaic inverter 100 to connect to the grid, reliability and security of the photovoltaic inverter 100 can be ensured.

However, the controller 120 cannot accurately determine, by comparing whether the frequency of the conditioned signal is the same as the frequency of the noise signal, whether the arc-fault circuit interrupter is functioning properly. When the controller 120 controls, based on this, the photovoltaic inverter 100 to connect to the grid, low reliability and security of the photovoltaic inverter 100 will be caused. Then, a circuit topology of the noise generation circuit 140 in the photovoltaic inverter 100 is complex, which results in high costs of the photovoltaic inverter 100.

In view of this, this embodiment of this application provides a power converter. A controller in the power converter compares a frequency of a conditioned signal with a frequency of a pulse signal, and compares a gain of the conditioned signal with a gain threshold corresponding to the frequency of the pulse signal, so as to more accurately determine whether an arc-fault circuit interrupter is functioning properly. When the controller controls, based on this, a power conversion circuit in the power converter to start operating, security and reliability of the power converter can be improved. In addition, a noise signal conditioning circuit in the power converter includes a first resistor and a capacitor that are connected in series, and a circuit topology of the power converter is simpler and costs are lower.

The power converter provided in this embodiment of this application may be an optimizer, or may be a photovoltaic inverter. This is not limited in this embodiment of this application. When the power converter is the optimizer or the photovoltaic inverter, the power converter may be used in a photovoltaic power generation system. This is not limited in this embodiment of this application.

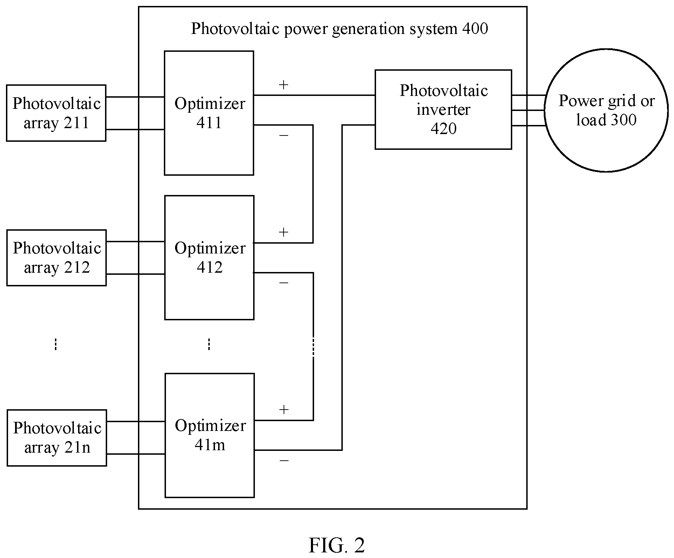

When the power converter provided in this embodiment of this application is the optimizer and is used in the photovoltaic power generation system, FIG. 2 is a schematic of a circuit topology of a photovoltaic power generation system 400 according to an embodiment of this application. The photovoltaic power generation system 400 includes optimizers 411 to 41m and a photovoltaic inverter 420, where m is a positive integer. Refer to FIG. 2. Each optimizer may be configured to connect to one photovoltaic array, and each photovoltaic array includes at least one photovoltaic module. For example, the optimizer 411 is configured to connect to a photovoltaic array 211, and the optimizer 41m is configured to connect to a photovoltaic array 21n, where n is a positive integer. Output ends of the m optimizers, namely, the optimizers 411 to 41m, are connected in series and then connected to an input end of the photovoltaic inverter 420. An output end of the photovoltaic inverter 420 is configured to connect to a power grid or a load 300.

Photovoltaic arrays 211 to 21n are configured to convert solar energy into direct currents. After power conversion is performed on the direct currents by using the optimizers 411 to 41m that are correspondingly connected to the photovoltaic arrays 211 to 21n, direct currents output by the m optimizers are connected in series and converge at the input end of the photovoltaic inverter 420. The photovoltaic inverter 420 is configured to convert the direct current into an alternating current and transmit the alternating current to the power grid or the load 300.

In a possible embodiment, the power converter provided in this embodiment of this application may alternatively be a photovoltaic inverter 420.

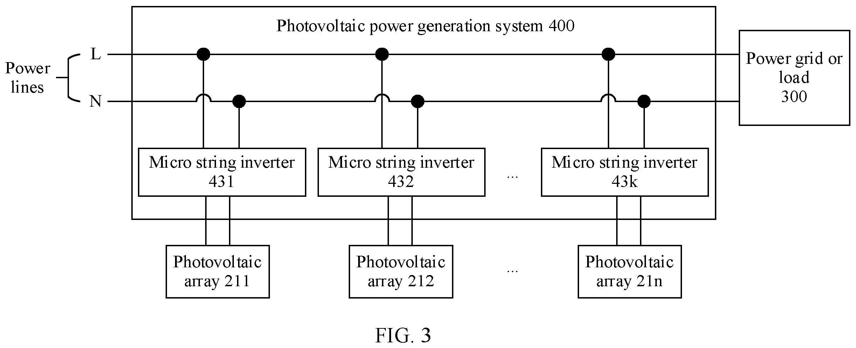

When the power converter provided in this embodiment of this application is a micro string inverter and is used in a photovoltaic power generation system, FIG. 3 is a schematic of a circuit topology of another photovoltaic power generation system 400 according to an embodiment of this application. The photovoltaic power generation system 400 includes micro string inverters 431 to 43k, where k is a positive integer. Refer to FIG. 3. Each micro string inverter may be configured to connect to one photovoltaic array, and each photovoltaic array includes at least one photovoltaic module. For example, the micro string inverter 431 is configured to connect to a photovoltaic array 211, and the micro string inverter 43k is configured to connect to a photovoltaic array 21n, where n is a positive integer. Output ends of the k micro string inverters, namely, the micro string inverters 431 to 43k, are connected in parallel by using power lines. The power lines include an alternating current live wire (live wire, L) and an alternating current neutral wire (neutral wire, N), and the power lines are connected to a power grid or a load 300.

Photovoltaic arrays 211 to 21n are configured to convert solar energy into direct currents. The micro string inverters 431 to 43k that are correspondingly connected to the photovoltaic array 211 to the photovoltaic array 21n convert the direct currents into alternating currents that are required by the power grid or the load 300 and that have electrical parameters such as a specific frequency and a specific voltage. The alternating current is then provided, by using the power lines, to the power grid or the load 300 for use.

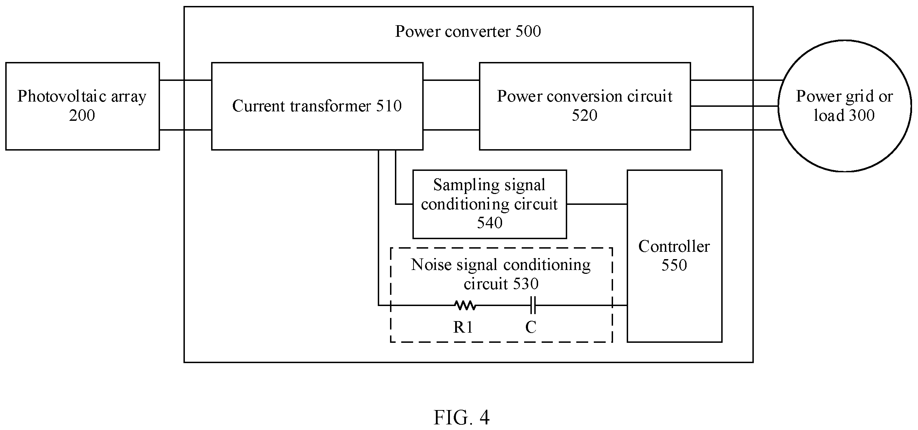

FIG. 4 is a schematic of a circuit topology of a power converter 500 according to an embodiment of this application. The power converter 500 includes a current transformer 510, a power conversion circuit 520, a noise signal conditioning circuit 530, a sampling signal conditioning circuit 540, and a controller 550. The noise signal conditioning circuit 530 includes a first resistor R1 and a capacitor C that are connected in series. A serial connection sequence of the first resistor R1 and the capacitor C is not limited in this embodiment of this application.

The current transformer 510 is configured to be connected between a photovoltaic array 200 and the power conversion circuit 520. An output end of the power conversion circuit 520 is configured to connect to a power grid or a load 300. The current transformer 510 is configured to detect a current output by the photovoltaic array 200. The power conversion circuit 520 is configured to perform power conversion on a direct current output by the photovoltaic array 200, to supply power to the power grid or the load 300. The power converter 500 has a function of an arc-fault circuit interrupter. The current transformer 510 and the sampling signal conditioning circuit 540 are configured to perform direct current arc detection.

Refer to FIG. 4. When the power converter 500 performs direct current arc detection, the controller 550 is configured to output a pulse signal. Optionally, the pulse signal includes a pulse frequency modulation (pulse frequency modulation, PFM) signal or a pulse width modulation (pulse width modulation, PWM) signal. This is not limited in this embodiment of this application.

In a possible embodiment, the controller 550 includes a digital signal processor (digital signal processor, DSP) chip or a microcontroller unit (microcontroller unit, MCU). The microcontroller unit may also be referred to as a single-chip microcomputer. This is not limited in this embodiment of this application.

The noise signal conditioning circuit 530 is configured to receive the pulse signal, and output a noise signal based on the pulse signal. Specifically, after the noise signal conditioning circuit 530 receives the pulse signal, the first resistor R1 in the noise signal conditioning circuit 530 is configured to serve as a current-limiting resistor to limit a current peak of the pulse signal, and the capacitor C is configured to serve as a direct-current blocking capacitor to block a direct-current component in the pulse signal, so that the noise signal conditioning circuit 530 outputs the noise signal. Compared with the noise generation circuit 140 in the foregoing photovoltaic inverter 100, the noise signal conditioning circuit 530 provided in this embodiment of this application includes a first resistor R1 and a capacitor C that are connected in series. A circuit topology of the noise signal conditioning circuit 530 is simpler, which can reduce costs of the power converter 500.

The current transformer 510 is configured to receive the noise signal and perform sampling, to output a sampled signal.

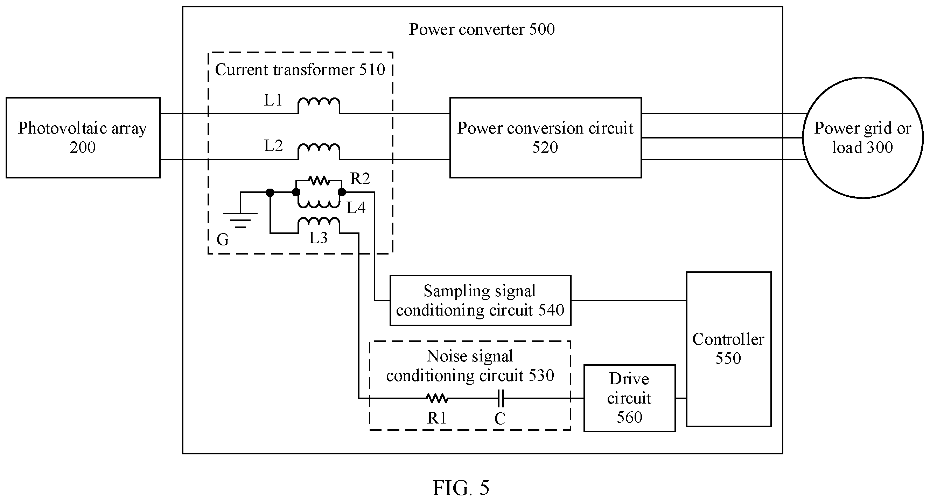

In a possible embodiment, as shown in FIG. 5, the current transformer 510 includes a second resistor R2, and a first coil L1, a second coil L2, a third coil L3, and a fourth coil L4 that are magnetically coupled to each other. One end of the first coil L1 is configured to connect to a positive electrode of the photovoltaic array 200, and the other end of the first coil L1 is connected to a positive input end of the power conversion circuit 520. One end of the second coil L2 is configured to connect to a negative electrode of the photovoltaic array 200, and the other end of the second coil L2 is connected to a negative input end of the power conversion circuit 520. One end of the third coil L3 is connected to an output end of the noise signal conditioning circuit 530. An input end of the noise signal conditioning circuit 530 is connected to an output end of the controller 550. The other end of the third coil L3 and one end of the fourth coil L4 are connected to a ground terminal G. The other end of the fourth coil L4 is connected to an input end of the sampling signal conditioning circuit 540. An output end of the sampling signal conditioning circuit 540 is connected to an input end of the controller 550. The second resistor R2 is connected to the fourth coil L4 in parallel.

A circuit including the third coil L3 and the noise signal conditioning circuit 530 may be referred to as a self-checking circuit. A circuit including the fourth coil L4, the second resistor R2, and the sampling signal conditioning circuit 540 may be referred to as a detection circuit. The self-checking circuit is configured to check whether a function of the detection circuit is normal, and the detection circuit is configured to detect whether there is a direct current arc in the power converter 500.

Specifically, refer to FIG. 5. That the current transformer 510 receives the noise signal and performs sampling, to output the sampled signal includes: The third coil L3 in the current transformer 510 receives the noise signal, and the fourth coil L4 samples the noise signal to output the sampled signal.

The sampling signal conditioning circuit 540 is configured to receive the sampled signal, and output a conditioned signal based on the sampled signal.

In a possible embodiment, the sampling signal conditioning circuit 540 includes a second-order band-pass filter. The sampling signal conditioning circuit 540 is specifically configured to receive the sampled signal, and perform filter-amplifier processing on the sampled signal to output the conditioned signal.

The controller 550 is further configured to: when an absolute value of a difference between a frequency of the conditioned signal and a frequency of the pulse signal is less than or equal to a frequency threshold, and a gain of the conditioned signal is greater than or equal to a gain threshold corresponding to the frequency of the pulse signal, control the power conversion circuit 520 to start operating. A specific value of the frequency threshold and a specific value of the gain threshold corresponding to the frequency of the pulse signal are not limited in this embodiment of this application.

In a possible embodiment, that the power conversion circuit 520 is controlled to start operating includes: The power conversion circuit 520 is controlled to perform power conversion, such as direct current to direct current (direct current to direct current, DCDC) power conversion or DCAC power conversion, on a direct current output by the photovoltaic array 200.

In a possible embodiment, the controller 120 may perform Fourier analysis on the conditioned signal, to determine the gain of the conditioned signal.

In the foregoing photovoltaic inverter 100, the controller 120 determines, by comparing whether the frequency of the conditioned signal is the same as the frequency of the noise signal, whether the arc-fault circuit interrupter is functioning properly, and controls, based on this, the photovoltaic inverter 100 to connect to the grid. In comparison, in the power converter 500 provided in this embodiment of this application, when the absolute value of the difference between the frequency of the conditioned signal and the frequency of the pulse signal is less than or equal to the frequency threshold, and the gain of the conditioned signal is greater than or equal to the gain threshold corresponding to the frequency of the pulse signal, the controller 550 controls the power conversion circuit 520 to start operating. Therefore, the power conversion circuit 520 can be controlled to start operating when it is more accurately determined that the arc-fault circuit interrupter in the power converter 500 is functioning properly, improving reliability and security of the power converter 500.

In a possible embodiment, before the power converter 500 is delivered from a factory, a gain threshold corresponding to a pulse signal at each frequency may be obtained by simulation, experiment, or the like. The gain threshold corresponding to the pulse signal at each frequency may be stored in the controller 550. Therefore, after the power converter 500 is delivered from a factory, when the absolute value of the difference between the frequency of the conditioned signal and the frequency of the pulse signal is less than or equal to the frequency threshold, and the gain of the conditioned signal is greater than or equal to the gain threshold corresponding to the frequency of the pulse signal, the controller 550 may determine that the arc-fault circuit interrupter is functioning properly, and control the power conversion circuit 520 to start operating.

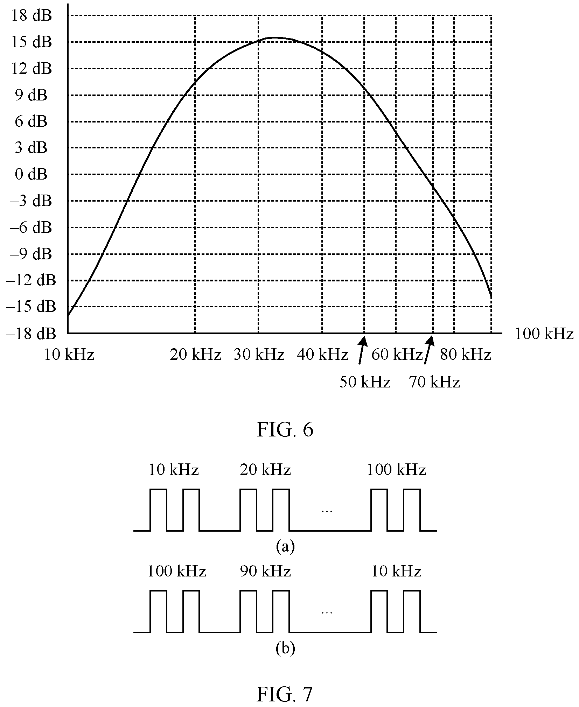

Specifically, before the power converter 500 is delivered from a factory, when the controller 550 outputs a pulse signal at each frequency, the controller 550 may obtain a gain of a conditioned signal corresponding to the pulse signal at each frequency. The gain of the conditioned signal may also be referred to as a designed gain threshold, and the gain of the conditioned signal may be used as a gain threshold of a pulse signal with a corresponding frequency. A relationship between the frequency of the pulse signal and the gain threshold corresponding to the frequency of the pulse signal may be represented by a Bode plot (Bode plot) shown in FIG. 6. A horizontal coordinate is the frequency of the pulse signal, measured in kilohertz (kHz), and a vertical coordinate is the gain threshold in decibel (decibel, dB) corresponding to the frequency of the pulse signal. For example, refer to FIG. 6. When the frequency of the pulse signal is 20 kHz, a gain threshold corresponding to the frequency 20 kHz of the pulse signal is 10 dB. For another example, refer to FIG. 6. When the frequency of the pulse signal is 30 kHz, a gain threshold corresponding to the frequency 30 kHz of the pulse signal is 15 dB. For a relationship between a frequency of another pulse signal and a gain threshold corresponding to the frequency of the another pulse signal, refer to FIG. 6. Details are not described herein in this embodiment of this application.

For example, refer to FIG. 5 and FIG. 6. For example, a frequency threshold is 0.1 kHz, in a direct current arc detection process, a frequency of a pulse signal output by the controller 550 is 20 kHz, the controller 550 receives a conditioned signal with a frequency of 20 kHz that is output by the sampling signal conditioning circuit 540, and a gain of the conditioned signal is 11 dB. When an absolute value of a difference between the frequency 20 kHz of the conditioned signal and the frequency 20 kHz of the pulse signal is 0 and less than the frequency threshold 0.1 kHz, and the gain 11 dB of the conditioned signal is greater than a gain threshold 10 dB corresponding to the frequency 20 kHz of the pulse signal, the controller 550 may determine that the arc-fault circuit interrupter is functioning properly, and control the power conversion circuit 520 to start operating.

In a possible embodiment, the controller 550 is further configured to: when the absolute value of the difference between the frequency of the conditioned signal and the frequency of the pulse signal is greater than the frequency threshold, or the gain of the conditioned signal is less than the gain threshold corresponding to the frequency of the pulse signal, determine that the arc-fault circuit interrupter in the power converter 500 does not function properly, generate an alarm to indicate that the arc-fault circuit interrupter does not function properly, and control the power converter 500 to shut down, thereby improving reliability and security of the power converter 500.

For example, refer to FIG. 5 and FIG. 6. For example, a frequency threshold is 0.1 kHz, in a direct current arc detection process, a frequency of a pulse signal output by the controller 550 is 20 kHz, the controller 550 receives a conditioned signal with a frequency of 19 kHz that is output by the sampling signal conditioning circuit 540, and a gain of the conditioned signal is 10 dB. When an absolute value of a difference between the frequency 19 kHz of the conditioned signal and the frequency 20 kHz of the pulse signal is 1 kHz and greater than the frequency threshold 0.1 kHz, the controller 550 may determine that the arc-fault circuit interrupter in the power converter 500 does not function properly, and control the power converter 500 to shut down.

For another example, refer to FIG. 5 and FIG. 6. For example, a frequency threshold is 0.1 kHz, in a direct current arc detection process, a frequency of a pulse signal output by the controller 550 is 20 kHz, the controller 550 receives a conditioned signal with a frequency of 20 kHz that is output by the sampling signal conditioning circuit 540, and a gain of the conditioned signal is 9 dB. When the gain 9 dB of the conditioned signal is less than a gain threshold 10 dB corresponding to the frequency 20 kHz of the pulse signal, the controller 550 may determine that the arc-fault circuit interrupter in the power converter 500 does not function properly, and control the power converter 500 to shut down.

For another example, refer to FIG. 5 and FIG. 6. For example, a frequency threshold is 0.1 kHz, in a direct current arc detection process, a frequency of a pulse signal output by the controller 550 is 20 kHz, the controller 550 receives a conditioned signal with a frequency of 19 kHz that is output by the sampling signal conditioning circuit 540, and a gain of the conditioned signal is 9 dB. When an absolute value of a difference between the frequency 19 kHz of the conditioned signal and the frequency 20 kHz of the pulse signal is 1 kHz and greater than the frequency threshold 0.1 kHz, and the gain 9 dB of the conditioned signal is less than a gain threshold 10 dB corresponding to the frequency 20 kHz of the pulse signal, the controller 550 may determine that the arc-fault circuit interrupter in the power converter 500 does not function properly, and control the power converter 500 to shut down.

In a possible embodiment, that the controller 550 outputs the pulse signal includes: During one direct current arc detection, the controller 550 outputs the pulse signal whose frequency varies based on a fixed step. The frequency varying based on the fixed step includes that the frequency is adjusted from a first frequency to a second frequency based on the fixed step, and the first frequency is less than the second frequency, or the first frequency is greater than the second frequency. Specific values of the first frequency and the second frequency are not limited in this embodiment of this application. In comparison with sequentially outputting a pulse signal at each frequency by the controller 550 during one direct current arc detection, during one direct current arc detection, the controller 550 outputs the pulse signal whose frequency varies based on the fixed step. This solution reduces a quantity of conditioned signals and pulse signals that need to be compared by the controller 550. Therefore, it can be more quickly determined whether the arc-fault circuit interrupter in the power converter 500 is functioning properly, and startup efficiency of the power converter 500 can be improved.

In a possible embodiment, refer to FIG. 6. A frequency range threshold of the pulse signal output by the controller 550 is greater than or equal to 10 kHz and less than or equal to 100 kHz. A specific value of the frequency range threshold of the pulse signal output by the controller 550 is not limited in this embodiment of this application.

In a possible embodiment, the fixed step includes 5 kHz, 10 kHz, 15 kHz, or 20 kHz. A specific value of the fixed step is not limited in this embodiment of this application.

For example, as shown in (a) in FIG. 7. For example, the first frequency is 10 kHz, the second frequency is 100 kHz, and the fixed step is 10 kHz. During one direct current arc detection, the controller 550 may output a pulse signal whose frequency increases progressively from the first frequency 10 kHz to the second frequency 100 kHz based on the fixed step 10 kHz.

For another example, as shown in (b) in FIG. 7. For example, the first frequency is 100 kHz, the second frequency is 10 kHz, and the fixed step is 10 kHz. During one direct current arc detection, the controller 550 may output a pulse signal whose frequency decreases progressively from the first frequency 100 kHz to the second frequency 10 kHz based on the fixed step 10 kHz.

In a possible embodiment, a frequency range threshold of the pulse signal output by the controller 550 is greater than or equal to 20 kHz and less than or equal to 60 kHz. In comparison with the frequency range threshold that is of the pulse signal output by the controller 550 and that is greater than or equal to 10 kHz and less than or equal to 100 kHz, the frequency range threshold of the pulse signal output by the controller 550 is reduced. This solution reduces a quantity of conditioned signals and pulse signals that need to be compared by the controller 550. Therefore, it can be more quickly determined whether the arc-fault circuit interrupter in the power converter 500 is functioning properly, and startup efficiency of the power converter 500 can be improved.

In a possible embodiment, the power conversion circuit 520 is a DCDC power conversion circuit, and the power converter 500 may be referred to as an optimizer. Refer to FIG. 2, an output of the power converter 500 is configured to connect to an input of the photovoltaic inverter 420, or the output of the power converter 500 is configured to connect to an output of at least one power converter 500 in series and then to the input of the photovoltaic inverter 420, and an output of the photovoltaic inverter 420 is configured to connect to the power grid or the load 300.

In a possible embodiment, the power conversion circuit 520 is a DCAC power conversion circuit. An output of the power conversion circuit 520 is configured to connect to the power grid or the load 300, and the power converter 500 may be referred to as a micro string inverter. The controller 550 is specifically configured to: when the absolute value of the difference between the frequency of the conditioned signal and the frequency of the pulse signal is less than or equal to the frequency threshold, and the gain of the conditioned signal is greater than or equal to the gain threshold corresponding to the frequency of the pulse signal, control the power conversion circuit 520 to establish a connection to the power grid or the load 300; or when the absolute value of the difference between the frequency of the conditioned signal and the frequency of the pulse signal is greater than the frequency threshold, or the gain of the conditioned signal is less than the gain threshold corresponding to the frequency of the pulse signal, control the power conversion circuit 520 to disconnect from the power grid or the load 300.

In a possible embodiment, the power conversion circuit 520 is a DCAC power conversion circuit, and the power converter 500 may be the photovoltaic inverter 420.

According to the power converter 500 provided in this embodiment of this application, when the absolute value of the difference between the frequency of the conditioned signal and the frequency of the pulse signal is less than or equal to the frequency threshold, and the gain of the conditioned signal is greater than or equal to the gain threshold corresponding to the frequency of the pulse signal, the controller 550 controls the power conversion circuit 520 to start operating. Therefore, the power conversion circuit 520 can be controlled to start operating when it is more accurately determined that the arc-fault circuit interrupter in the power converter 500 is functioning properly, improving reliability and security of the power converter 500. In addition, the noise signal conditioning circuit 530 includes the first resistor R1 and the capacitor C that are connected in series. The circuit topology of the noise signal conditioning circuit 530 is simpler, which can reduce costs of the power converter 500.

In a possible embodiment, as shown in FIG. 5, the power converter 500 further includes a drive circuit 560. The drive circuit 560 is disposed between the controller 550 and the noise signal conditioning circuit 530, so that an additional drive capability can be provided when a drive capability of the controller 550 is insufficient, thereby avoiding that the controller 550 cannot detect whether the arc-fault circuit interrupter is functioning properly, and improving reliability of the power converter 500.

In a possible embodiment, the drive circuit 560 includes a buffer driver, a gate circuit, or a push-pull circuit. This is not limited in this embodiment of this application.

According to the power converter 500 provided in this embodiment of this application, the drive circuit 560 is disposed between the controller 550 and the noise signal conditioning circuit 530, so that the additional drive capability can be provided when the drive capability of the controller 550 is insufficient, thereby avoiding that the controller 550 cannot detect whether the arc-fault circuit interrupter is functioning properly, and improving reliability of the power converter 500.

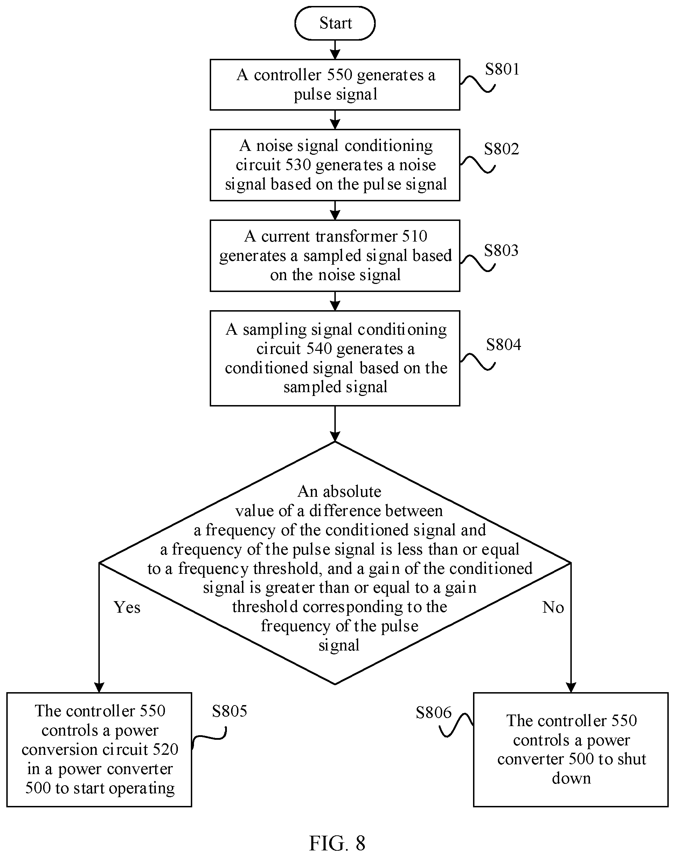

As shown in FIG. 8, an embodiment of this application further provides a power converter control method, applied to the foregoing power converter 500. The method includes step S801 to step S805.

S801: A controller 550 generates a pulse signal.

In a possible embodiment, that the controller 550 generates the pulse signal includes: During one direct current arc detection, the controller 550 generates the pulse signal whose frequency varies based on a fixed step. The frequency varying based on the fixed step includes that the frequency is adjusted from a first frequency to a second frequency based on the fixed step, and the first frequency is less than the second frequency, or the first frequency is greater than the second frequency.

In a possible embodiment, refer to FIG. 6. A frequency range threshold of the pulse signal output by the controller 550 is greater than or equal to 10 kHz and less than or equal to 100 kHz. A specific value of the frequency range threshold of the pulse signal output by the controller 550 is not limited in this embodiment of this application.

In a possible embodiment, the fixed step includes 5 kHz, 10 kHz, 15 kHz, or 20 kHz. A specific value of the fixed step is not limited in this embodiment of this application.

In a possible embodiment, a frequency range threshold of the pulse signal output by the controller 550 is greater than or equal to 20 kHz and less than or equal to 60 kHz. In comparison with the frequency range threshold that is of the pulse signal output by the controller 550 and that is greater than or equal to 10 kHz and less than or equal to 100 kHz, the frequency range threshold of the pulse signal output by the controller 550 is reduced. This solution reduces a quantity of conditioned signals and pulse signals that need to be compared by the controller 550. Therefore, it can be more quickly determined whether an arc-fault circuit interrupter in the power converter 500 is functioning properly, and startup efficiency of the power converter 500 can be improved.

S802: A noise signal conditioning circuit 530 generates a noise signal based on the pulse signal.

S803: A current transformer 510 generates a sampled signal based on the noise signal.

S804: A sampling signal conditioning circuit 540 generates a conditioned signal based on the sampled signal.

S805: When an absolute value of a difference between a frequency of the conditioned signal and a frequency of the pulse signal is less than or equal to a frequency threshold, and a gain of the conditioned signal is greater than or equal to a gain threshold corresponding to the frequency of the pulse signal, the controller 550 controls a power conversion circuit 520 in the power converter 500 to start operating. A specific value of the frequency threshold and a specific value of the gain threshold corresponding to the frequency of the pulse signal are not limited in this embodiment of this application.

According to the power converter control method provided in this embodiment of this application, when the absolute value of the difference between the frequency of the conditioned signal and the frequency of the pulse signal is less than or equal to the frequency threshold, and the gain of the conditioned signal is greater than or equal to the gain threshold corresponding to the frequency of the pulse signal, the controller 550 controls the power conversion circuit 520 in the power converter 500 to start operating. Therefore, the power conversion circuit 520 in the power converter 500 can be controlled to start operating when it is more accurately determined that the arc-fault circuit interrupter in the power converter 500 is functioning properly, improving reliability and security of the power converter 500.

In a possible embodiment, as shown in FIG. 8, the power converter control method provided in this embodiment of this application further includes step S806. Either step S806 or step S805 may be performed based on a relationship between the frequency threshold and the absolute value of the difference between the frequency of the conditioned signal and the frequency of the pulse signal, and a relationship between the gain of the conditioned signal and the gain threshold corresponding to the frequency of the pulse signal.

S806: When an absolute value of a difference between a frequency of the conditioned signal and a frequency of the pulse signal is greater than a frequency threshold, or a gain of the conditioned signal is less than a gain threshold corresponding to the frequency of the pulse signal, the controller 550 controls the power converter 500 to shut down.

According to the power converter control method provided in this embodiment of this application, when the absolute value of the difference between the frequency of the conditioned signal and the frequency of the pulse signal is greater than the frequency threshold, or the gain of the conditioned signal is less than the gain threshold corresponding to the frequency of the pulse signal, the controller 550 determines that the arc-fault circuit interrupter in the power converter 500 does not function properly, generates an alarm to indicate that the arc-fault circuit interrupter does not function properly, and controls the power converter 500 to shut down, thereby improving reliability and security of the power converter 500.

Based on this, an embodiment of this application further provides a photovoltaic power generation system. The photovoltaic power generation system includes a power converter.

In a possible embodiment, a schematic of a circuit topology of the photovoltaic power generation system is the schematic of the circuit topology of the photovoltaic power generation system 400 shown in FIG. 2. The photovoltaic power generation system 400 includes optimizers 411 to 41m and a photovoltaic inverter 420, where m is a positive integer. Refer to FIG. 2. Each optimizer may be configured to connect to one photovoltaic array, and each photovoltaic array includes at least one photovoltaic module. For example, the optimizer 411 is configured to connect to a photovoltaic array 211, and the optimizer 41m is configured to connect to a photovoltaic array 21n, where n is a positive integer. Output ends of the m optimizers, namely, the optimizers 411 to 41m, are connected in series and then connected to an input end of the photovoltaic inverter 420. An output end of the photovoltaic inverter 420 is configured to connect to a power grid or a load 300. The optimizers 411 to 41m may also be referred to as power converters. A schematic of a circuit topology of any optimizer may be the schematic of the circuit topology of the power converter 500 shown in FIG. 4 or FIG. 5.

In a possible embodiment, the schematic of the circuit topology of the photovoltaic power generation system is the schematic of the circuit topology of the photovoltaic power generation system 400 shown in FIG. 3. The photovoltaic power generation system 400 includes micro string inverters 431 to 43k, where k is a positive integer. Each micro string inverter may be configured to connect to one photovoltaic array, and each photovoltaic array includes at least one photovoltaic module. For example, the micro string inverter 431 is configured to connect to a photovoltaic array 211, and the micro string inverter 43k is configured to connect to a photovoltaic array 21n, where n is a positive integer. Output ends of the k micro string inverters, the micro string inverters 431 to 43k, are connected in parallel by using power lines. The power lines include an alternating current live wire and an alternating current neutral wire, and the power lines are connected to a power grid or a load 300. The micro string inverters 431 to 43k may also be referred to as power converters. A schematic of a circuit topology of any micro string inverter may be the schematic of the circuit topology of the power converter 500 shown in FIG. 4 or FIG. 5.

The foregoing detailed description of the power converter 500 and beneficial effect analysis may be correspondingly cited to the power converter control method and the photovoltaic power generation system 400. Details are not described in this embodiment of this application.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A power converter, wherein the power converter comprises a current transformer, a power conversion circuit, a noise signal conditioning circuit, a sampling signal conditioning circuit, and a controller, the noise signal conditioning circuit comprises a first resistor and a capacitor that are connected in series, the current transformer is configured to be connected between a photovoltaic array and the power conversion circuit, the current transformer is configured to detect a current output by the photovoltaic array, the power conversion circuit is configured to perform power conversion on a direct current output by the photovoltaic array, and the current transformer and the sampling signal conditioning circuit are configured to perform direct current arc detection;
the controller is configured to output a pulse signal;
the noise signal conditioning circuit is configured to receive the pulse signal, and output a noise signal based on the pulse signal;
the current transformer is configured to receive the noise signal and perform sampling, to output a sampled signal;
the sampling signal conditioning circuit is configured to receive the sampled signal, and output a conditioned signal based on the sampled signal; and
the controller is further configured to: when an absolute value of a difference between a frequency of the conditioned signal and a frequency of the pulse signal is less than or equal to a frequency threshold, and a gain of the conditioned signal is greater than or equal to a gain threshold corresponding to the frequency of the pulse signal, control the power conversion circuit to start operating.

2. The power converter according to claim 1, wherein
the controller is further configured to: when the absolute value of the difference between the frequency of the conditioned signal and the frequency of the pulse signal is greater than the frequency threshold, or the gain of the conditioned signal is less than the gain threshold corresponding to the frequency of the pulse signal, control the power converter to shut down.

3. The power converter according to claim 1 or 2, wherein
the controller is specifically configured to output, during one direct current arc detection, the pulse signal whose frequency varies based on a fixed step, wherein the frequency varying based on the fixed step comprises that the frequency is adjusted from a first frequency to a second frequency based on the fixed step, and the first frequency is less than the second frequency, or the first frequency is greater than the second frequency.

4. The power converter according to claim 3, wherein the fixed step comprises 5 kHz, 10 kHz, 15 kHz, or 20 kHz.

5. The power converter according to any one of claims 1 to 4, wherein a frequency range threshold of the pulse signal is greater than or equal to 20 kHz and less than or equal to 60 kHz.

6. The power converter according to any one of claims 1 to 5, wherein the power converter further comprises a drive circuit, the drive circuit is disposed between the controller and the noise signal conditioning circuit, and the sampling signal conditioning circuit is a second-order band-pass filter.

7. The power converter according to any one of claims 1 to 6, wherein the current transformer comprises a second resistor, and a first coil, a second coil, a third coil, and a fourth coil that are magnetically coupled to each other;
one end of the first coil is configured to connect to a positive electrode of the photovoltaic array, the other end of the first coil is connected to a positive input end of the power conversion circuit, one end of the second coil is configured to connect to a negative electrode of the photovoltaic array, and the other end of the second coil is connected to a negative input end of the power conversion circuit; and
one end of the third coil is connected to an output end of the noise signal conditioning circuit, the other end of the third coil and one end of the fourth coil are connected to a ground terminal, the other end of the fourth coil is connected to an input end of the sampling signal conditioning circuit, and the second resistor is connected to the fourth coil in parallel.

8. The power converter according to any one of claims 1 to 7, wherein the power conversion circuit is a DCDC power conversion circuit, an output of the power converter is configured to connect to an input of an inverter, or an output of the power converter is configured to connect to an output of at least one power converter in series and then to an input of the inverter, and an output of the inverter is configured to connect to a power grid or a load.

9. The power converter according to any one of claims 1 to 7, wherein the power conversion circuit is a DCAC power conversion circuit, and an output of the power conversion circuit is configured to connect to a power grid or a load; and
the controller is specifically configured to: when the absolute value of the difference between the frequency of the conditioned signal and the frequency of the pulse signal is less than or equal to the frequency threshold, and the gain of the conditioned signal is greater than or equal to the gain threshold corresponding to the frequency of the pulse signal, control the power conversion circuit to establish a connection to the power grid or the load; or
when the absolute value of the difference between the frequency of the conditioned signal and the frequency of the pulse signal is greater than the frequency threshold, or the gain of the conditioned signal is less than the gain threshold corresponding to the frequency of the pulse signal, control the power conversion circuit to disconnect from the power grid or the load.

10. A power converter control method, applied to a power converter, wherein the method comprises:
generating a pulse signal;
generating a noise signal based on the pulse signal;
generating a sampled signal based on the noise signal;
generating a conditioned signal based on the sampled signal; and
when an absolute value of a difference between a frequency of the conditioned signal and a frequency of the pulse signal is less than or equal to a frequency threshold, and a gain of the conditioned signal is greater than or equal to a gain threshold corresponding to the frequency of the pulse signal, controlling a power conversion circuit in the power converter to start operating.

11. The method according to claim 10, wherein the method further comprises:
when the absolute value of the difference between the frequency of the conditioned signal and the frequency of the pulse signal is greater than the frequency threshold, or the gain of the conditioned signal is less than the gain threshold corresponding to the frequency of the pulse signal, controlling the power converter to shut down.

12. The method according to claim 10 or 11, wherein generating the pulse signal comprises:
generating, during one direct current arc detection, the pulse signal whose frequency varies based on a fixed step, wherein the frequency varying based on the fixed step comprises that the frequency is adjusted from a first frequency to a second frequency based on the fixed step, and the first frequency is less than the second frequency, or the first frequency is greater than the second frequency.
